# FASCICULE DE BREVET EUROPEEN

(11) **EP 1 037 480 B1**
(45) Date de publication et mention de la délivrance du brevet: **18.09.2002**
(21) Numéro de dépôt: 00400615.1
(22) Date de dépôt: 07.03.2000
(51) Int. Cl.: H04Q 7/32, H04B 7/26, H04B 1/16

(54) **Procédé de détection de signaux de calage en fréquence, et téléphone mobile correspondant**
Verfahren zur Detektion von Frequenzverriegelungsignalen, und mobiles Telefon dafür
Method for detecting frequency locking signals, and mobile telephone therefor

(30) Priorité: 18.03.1999 FR 9903384
(43) Date de publication de la demande: 20.09.2000
(73) Titulaire: SAGEM S.A., 75015 Paris (FR)
(72) Inventeur: Romao, Fernando, 78360 Montesson (FR)
(74) Mandataire: Schmit, Christian Norbert Marie

(56) Documents cités:
- EP-A- 0 717 512
- US-A- 5 027 428
- US-A- 5 390 216

## Description

La présente invention a pour objet un téléphone mobile et procédé de détection par un tel téléphone mobile de signaux de calage en fréquence. Son domaine d'application est celui de la téléphonie mobile. Les signaux détectés sont de préférence, mais pas seulement, des signaux de calage en fréquence. Le but de l'invention est d'augmenter la capacité de veille d'un téléphone mobile.

A l'heure actuelle un des facteurs discriminant les différents modèles de téléphone mobile aux yeux du public est leur autonomie. Cette dernière est liée à des facteurs d'encombrement et de consommation.

Les considérations d'encombrement tendent à réduire la taille de la batterie, donc la quantité d'énergie disponible pour le téléphone mobile. La consommation doit donc être réduite au strict minimum.

Une fois mis en service, le téléphone mobile cherche tout de suite à se connecter à un réseau de téléphonie mobile. Il faut en effet qu'un abonné puisse recevoir un appel téléphonique entrant ou émettre un appel sortant. Cette mise en service donne lieu à une signalisation importante entre le téléphone mobile et le réseau auquel il est connecté. Un réseau est constitué dans un domaine géographique par un ensemble de stations de base. Chaque station de base crée une cellule, zone globalement circulaire autour de la station de base, plus ou moins grande selon qu'elle est située en zone rurale ou urbaine. La connexion initiale d'un téléphone mobile à un réseau consiste en une recherche de la meilleure cellule. Autrement dit le téléphone mobile recherche une station de base dont il reçoit le signal le meilleur ou le plus fort. Une fois cette opération effectuée il s'enregistre dans les circuits de la station de base ainsi sélectionnée. Cette phase est une phase dite de campement. Après ces opérations le réseau est en mesure de localiser le téléphone mobile.

Le principal intérêt d'un téléphone mobile réside dans sa mobilité. Cela implique que le réseau sache à chaque instant où se situe un téléphone mobile, y compris lorsque ce dernier se déplace. Il existe pour cela un protocole d'échange de données permanent entre un téléphone mobile et le réseau. Le réseau transmet au téléphone mobile des informations diverses avec une période variant de 235 millisecondes à deux secondes. Ces informations contiennent entre autre une liste des cellules que le; téléphone mobile doit surveiller. Par exemple, en téléphonie mobile de type GSM (Global System for Mobile communication, Système Global pour communication Mobile) chaque station de base se voit affecter un certain nombre de bandes de 200 KHz. Chaque bande est centrée sur une fréquence. Une fréquence particulière, par station de base, est en outre affectée à un signal de balise Fb. Cette balise est écoutée par les téléphones mobiles qui sont connectés à une station de base, mais aussi par les mobiles pour lesquels la station de base en question figure sur la liste des cellules à écouter.

Dans un système de codage de type TDMA (Time Division Multiple Access, Accès Multiple à Répartition dans le Temps), une synchronisation de trame est réalisée. Le signal de balise obéit alors à des même lois de découpage en trame que les autres fréquences. Pour ce découpage il existe des fenêtres temporelles de 577 microsecondes. Ces fenêtres temporelles sont regroupées par huit pour former des trames. A leur tour 51 de ces trames forment une multitrame dont la durée est approximativement de 235 millisecondes. Une multitrame contient des informations de synchronisation et de calage entre la station de base et les téléphones mobiles, des informations permettant de prendre des rendez-vous temporels avec des téléphones mobiles qu'elle gère, et des informations d'appel entrant ou de liste de cellules à surveiller et destinées à un téléphone en particulier.

Une multitrame contient en particulier des trames FCH (Frequency Channel, Canal de Fréquence). Dans une trame FCH le signal de porteuse, à la fréquence porteuse, est modulé par une sinusoïde pure à 67,7 KHz. Ce signal de modulation à 67,7 KHz est appelé signal FCB (Frequency Burst, Bref Signal de Fréquence). Cette trame FCH apparaît approximativement toutes les 48 millisecondes. Elle permet le calage en fréquence du téléphone mobile sur une station de base. Lorsque le réseau signifie au téléphone mobile qu'il doit écouter une nouvelle cellule, ce dernier commence par faire une recherche de signal FCB concernant cette cellule. Cette recherche met en oeuvre toute la chaîne de traitement du téléphone mobile et dure en moyenne 24 millisecondes, durant lesquelles sont utilisés un convertisseur analogique numérique, un microprocesseur et un processeur de traitement de signal. Cette recherche est très consommatrice d'énergie parce que, notamment le processeur de traitement de signal consomme beaucoup d'énergie. De plus si le téléphone se déplace, la liste des cellules à surveiller évolue fréquemment. La consommation d'énergie n'en est que plus grande. Dans les faits quand le téléphone mobile est en mouvement la consommation en veille peut augmenter de 50%. Et cela, même si on met en oeuvre l'enseignement du document US-A 5 027 428 qui maintient l'activité, même réduite, d'un microprocesseur principal.

Dans l'invention on remédie à ce problème de consommation en faisant faire la recherche de signal FCB par un circuit spécialisé. Celui-ci, de par sa complexité relativement faible par rapport à un microprocesseur ou un processeur de traitement de signal, consomme peu d'énergie. De plus durant son activité, le microprocesseur et les autres circuits intégrés inutiles, seront mis en sommeil. Dans l'invention il existe donc deux chaînes de traitement, l'une principale, l'autre secondaire. Les deux chaînes communiquent entre elles via des registres accessibles par les deux chaînes. A titre de perfectionnement, lorsqu'il n'est pas utile le circuit spécialisé est mis en sommeil. L'économie d'énergie réalisée est alors substantielle. En pratique ce dispositif permet d'économiser un facteur 2 sur l'énergie nécessaire pour la détection de FCB.

L'invention a donc pour objet un téléphone mobile comportant :
- une chaîne de traitement principale pour traiter des signaux radioélectriques, et
- des moyens de mise en sommeil et de réveil de la chaîne de traitement principale,
caractérisé en ce qu'il comporte :
- une chaîne de traitement secondaire permettant d'entretenir une activité réduite de réception et de traitement de certains signaux radioélectriques pendant le sommeil de la chaîne principale,
- des registres accessibles à la fois par la chaîne de traitement principale et par la chaîne de traitement secondaire, pour paramètre la chaîne de traitement secondaire, de préférence en fréquence et en gain de réception, et pour restituer des résultats de traitements de la chaîne secondaire.

L'invention a également pour objet un procédé de détection de signaux par un téléphone mobile dans lequel, dans une chaîne de traitement principale :
- on reçoit des signaux radioélectriques pour produire des signaux démodulés,
- on produit, à partir des signaux démodulés, des signaux numériques traités, représentant notamment des signaux de calage en fréquence,
caractérisé en ce que :
- on met à jour des paramètres, enregistrés dans des registres accessibles à la fois par la chaîne de traitement principale et par une chaîne de traitement secondaire, de configuration d'une chaîne de traitement secondaire,
- on met en sommeil la chaîne de traitement principale,
- on met en service la chaîne de traitement secondaire, permettant d'entretenir une activité réduite de réception et de traitement de certains signaux radioélectriques, pendant le sommeil de la chaîne de traitement principale,
- on met à jour les registres en fonction de résultats de traitements de la chaîne de traitement secondaire.

L'invention sera mieux comprise à la lecture de la description qui suit et à l'examen des figures qui l'accompagnent. Celles-ci ne sont présentées qu'à titre indicatif et nullement limitatif de l'invention. Les figures montrent :
- Figure 1: une représentation d'un dispositif selon l'invention de détection FCB ;
- Figure 2 : un premier dispositif de détection des FCB par le circuit spécialisé ;
- Figure 3 : un deuxième dispositif de détection des FCB par le circuit spécialisé ;
- Figure 4 : une illustration des étapes du procédé de mise en oeuvre du dispositif selon l'invention.

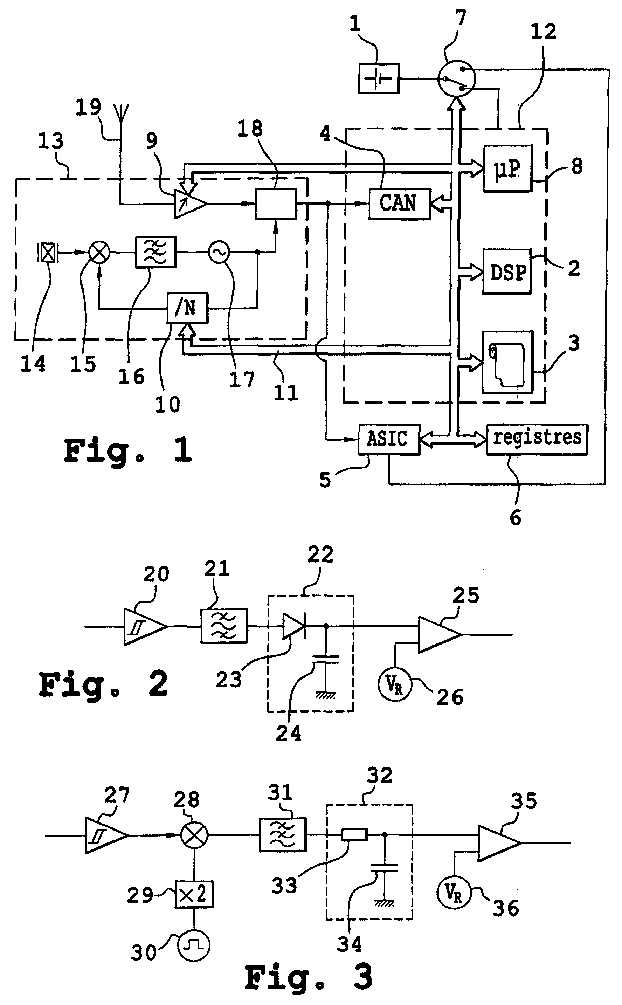

La figure 1 montre dans un téléphone mobile selon l'invention un circuit 13 radioélectrique contenant: un aérien 19 qui attaque un démodulateur 18 via un amplificateur 9 à gain variable. Un oscillateur 14 est branché en cascade avec un comparateur 15 de fréquence, un filtre passe-bas 16, un oscillateur 17 commandé en tension. La sortie de l'oscillateur 17 est connectée au démodulateur 18. La sortie de l'oscillateur 17 est aussi reliée au comparateur 15 via un diviseur 10 de fréquence. Le rôle de ce circuit 13 est de fournir en sortie du démodulateur 18 des signaux démodulés résultant du traitement, par le circuit 13, des signaux reçus par l'aérien 19. Les autres organes du téléphone mobile non utiles à la compréhension de l'invention ont été omis

La figure 1 montre aussi un circuit 12 de traitement des signaux démodulés, contenant un convertisseur 4 analogique numérique, un microprocesseur 8, un processeur 2 de traitement de signal et une mémoire 3. Le microprocesseur 8 et le processeur 2 ont été représentés de manière séparée dans la figure, cela dans le but d'illustrer l'activité importante de la chaîne 12 de traitement. Dans la pratique le microprocesseur 8 et le processeur 2 peuvent ne faire partie que d'une seule et même circuit intégré.

A côté des deux circuits 12 et 13, il y a une source d'alimentation 1 reliée à un commutateur 7, un circuit 5 spécialisé selon l'invention, et des registres 6. Le commutateur 7 peut alimenter soit la chaîne de traitement 12, soit le circuit 5.

Les éléments 2 à 10 de la figure 1 sont reliés entre eux par l'intermédiaire d'un bus 11. La sortie du démodulateur 18 est reliée d'une part au convertisseur analogique numérique 4, d'autre part au circuit 5.

Dans la suite, lorsqu'une action est attribuée au microprocesseur 8, ou au processeur 2, il faudra comprendre que celle-ci est exécutée sous le contrôle d'un programme contenu dans la mémoire 3.

Dans le cas général, qui était le seul avant l'invention, un téléphone mobile ne comportait que les circuits 12 et 13 dont la réunion forme la chaîne de traitement principale d'un téléphone mobile. Une telle chaîne 12-13 est capable de traiter la majorité des événements prévus par la norme GSM. Son fonctionnement est le suivant. Un téléphone mobile reçoit par l'intermédiaire de l'aérien 19 un signal radioélectrique. La puissance de ce signal est ajustée grâce à l'amplificateur 9 à gain variable commandé par le microprocesseur 8. Cet ajustement est nécessaire au bon fonctionnement du démodulateur 18. En effet, un signal trop puissant entraînerait des phénomènes de saturation qui perturberait la démodulation. De même un signal trop faible ne pourrait pas être démodulé. En fonction de la fréquence qu'il souhaite écouter, le microprocesseur 8 commande le diviseur de fréquences 10. Cela aura pour effet de modifier la sortie du comparateur 15, donc la consigne appliquée à l'oscillateur 17. Le démodulateur 18 est alors en mesure de démoduler les signaux reçus par l'aérien 19 et situés dans la bande sélectionnée par le microprocesseur 8.

Les signaux démodulés sont alors transmis au convertisseur 4 analogique numérique. Celui-ci les transforme en signaux numériques équivalents. Le microprocesseur 8, et/ou le processeur 2, sont alors en mesure de traiter ces signaux, notamment de déterminer s'il s'agit d'un signal FCB ou pas. Cette détermination est effectuée de manière connue.

Avec l'invention, la sortie du démodulateur 18 est aussi reliée à l'entrée du circuit 5, qui avec le circuit 13 forment une chaîne de traitement secondaire et spécialisée. Le rôle du circuit 5 est, dans un exemple, de déterminer si des signaux FCB lui sont soumis ou non. Par l'intermédiaire du bus 11 le circuit 5 peut agir sur le diviseur 10 de fréquence et l'amplificateur 9 du circuit 13 radioélectrique pour déterminer quelle fréquence ce circuit 13 écoute. Les résultats de cette écoute sont stockés par le circuit 5 dans les registres 6. Dans une étape ultérieure le microprocesseur 8 peut lire les registres 6, auxquels il a aussi accès par le même bus 11. Il peut ainsi connaître les résultats de la détection. La structure de ces registres 6 peut être un tableau à deux colonnes. Une première colonne de consignes qui seront écrites par le microprocesseur 8 et lues par le circuit 5 et qui contient la liste des fréquences à écouter. Une colonne de résultats écrits par le circuit 5 et lus par le microprocesseur 8, qui contient le résultat des détections sur chacune des fréquences.

La figure 2 montre, reliés en cascade, un comparateur 20 de préférence à hystérésis, un filtre 21 passe bande, un détecteur d'enveloppe 22 et un comparateur 25. Dans l'exemple choisi le détecteur d'enveloppe 22 a été réalisé à l'aide d'une diode 23 et d'un condensateur 24. La diode 22 relie l'entrée et la sortie du détecteur d'enveloppe. Le condensateur lie la sortie du détecteur d'enveloppe à une masse. Une deuxième entrée du comparateur 25 est reliée à une source 26 de tension de référence. L'ensemble représenté dans la figure 2 est contenu dans le circuit 5. L'entrée du circuit 5 correspondant à l'entrée du comparateur 20 à hystérésis. L'emploi d'un comparateur à hystérésis permet d'éviter que le signal de sortie du comparateur 20 n'oscille à cause d'un bruit présent dans le signal d'entrée du comparateur 20.

Lorsque le signal démodulé issu du démodulateur 18 attaque le circuit 5 il est transformé en un signal carré par le comparateur 20 à hystérésis. Ce signal est alors soumis au filtre 21 passe bande. Ce filtre est centré sur une fréquence de 67,7 KHz. Cela correspond à la sinusoïde pure codant le signal FCB. Si le signal d'entrée contient une information de type FCB, la sortie du filtre 21 est une sinusoïde de fréquence avoisinant 67,7 KHz. Sinon le signal à la sortie filtre sera nul, ou un bruit insignifiant. Dans ce dernier cas, à la sortie du détecteur 22 d'enveloppe on aura une tension nulle. La tension seuil délivrée par la source 26 ne sera donc pas atteint, le comparateur 25 ne détectera alors rien. Si le détecteur d'enveloppe 22 est attaqué par une sinusoïde à 67,7 KHz, la diode 23 supprime les alternances négatives. Puis le condensateur 24 effectue la moyenne des alternances positives restantes, créant ainsi une tension quasi continue sur une première entrée du comparateur 25. Si cette tension est supérieure à la tension de la source 26, le comparateur considère qu'on est bien en présence d'un signal FCB.

La figure 3 montre reliés en cascade un comparateur 27 de préférence à hystérésis, un mélangeur 28, un filtre 31 passe-bas, un filtre 32 moyennant et un comparateur 35. Une deuxième entrée du comparateur 28 est reliée à une horloge 30 par l'intermédiaire d'un multiplicateur 29 par deux. Dans l'exemple choisi, le filtre 32 moyennant est réalisé par une résistance 33 et un condensateur 34. La résistance 33 relie l'entrée du filtre 32 à sa sortie, le condensateur 34 relie la sortie du filtre 32 à une masse. Une deuxième entrée du comparateur 35 est reliée à une source 36 de tension de référence. L'horloge 30 fournit un signal carré à une fréquence de 32 KHz. Il s'agit, dans l'exemple, de l'horloge calendaire, présente dans tous les téléphones mobiles qui donne l'heure, de manière connue. La deuxième entrée du comparateur 28 est donc attaqué par un signal carré à 64 KHz. L'ensemble décrit par la figure 3, à l'exclusion de l'horloge 30, est contenu dans le circuit 5 à la place de l'ensemble décrit dans la figure 2. L'entrée du circuit correspond alors à l'entrée du comparateur 27. Dans ce cas, lorsque le circuit est attaqué par un signal démodulé, celui-ci est transformé en signal carré par le comparateur 27 à hystérésis. Dans le cas où le signal contiendrait une information de type FCB, son passage dans le mélangeur 28 produirait un signal carré à une fréquence avoisinant 3,7 KHz. Cela est le résultat de la différence entre les deux entrées du mélangeur 28, l'une à 64 KHz, l'autre à 67,7 KHz correspondant au signal FCB. La sortie du mélangeur 28 est soumise à un filtre 31 passe bas dont la fréquence de coupure est de 4 KHz. Cela permet de différencier les signaux FCB de ceux qui n'en sont pas. Le filtre 32 moyennant permet d'obtenir à partir du signal carré sortant du filtre 31 une tension quasi continue que l'on applique sur la première entrée du comparateur 35. Si cette tension est supérieure à la tension 36 de référence le comparateur indique la détection d'une information de type FCB.

Que le circuit 5 ait été réalisé à partir de la figure 2 ou de la figure 3, la sortie du comparateur 25 ou 35, est suivie par un circuit logique, non représenté mais de type connu, qui permet l'écriture des résultats de la détection dans les registres 6. Dans l'exemple simple décrit, le résultat est binaire : le signal FCB a été ou n'a pas été détecté. Il serait possible toutefois, notamment en utilisant un circuit 5 plus évolué, de disposer d'informations plus complètes. La fonction du circuit 5 est une version simplifiée de celles effectuées dans le microprocesseur 8. Plus cette fonction est simplifiée, moins la consommation est élevée.

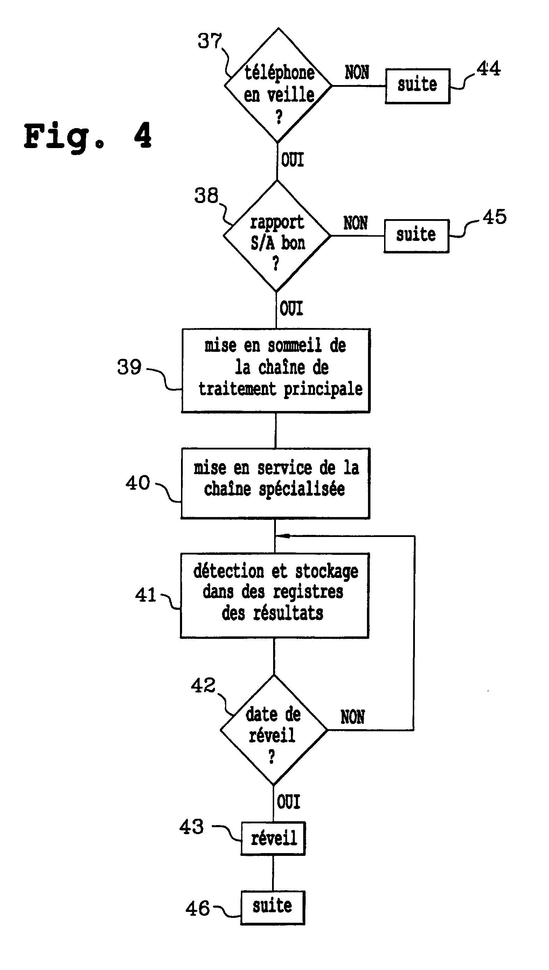

La figure 4 illustre les étapes de mise en oeuvre des moyens précédemment décrits. Dans une étape 37 préliminaire le microprocesseur 8 cherche à déterminer si le téléphone est en veille ou pas. L'état de veille se caractérise par l'absence de communication avec un autre abonné du réseau, mais pas par l'absence de connexion avec le réseau. Si le téléphone est en relation avec un autre abonné, ou en phase d'établissement de connexion avec un autre abonné, on passe à une étape 44 de suite, sinon on passe à une étape 38.

Dans l'étape 38, le microprocesseur 8 détermine si le rapport signal sur bruit du canal de balise est satisfaisant. Cela revient à déterminer si des signaux radioélectriques porteurs de sens sont suffisamment différenciés de ceux qui n'en sont pas porteurs. Cette mesure peut être effectuée, après démodulation par le circuit 13 radioélectrique, après la numérisation par le convertisseur 4 analogique numérique, et après décodage par mise en oeuvre de l'algorithme de Viterbi. Les circuits de décodage sont contenus dans le processeur 2 qui travaille sous le contrôle du microprocesseur 8. Si les résultats ne sont pas satisfaisants, on passe à une étape 45, sinon on passe à l'étape 39. Le caractère satisfaisant du décodage est donné, sous la forme d'un signal de qualité, par les circuits de décodage en plus de l'information décodée. On se sert de ce signal de qualité pour le test de l'étape 38.

Dans une étape 39 le microprocesseur 8 initialise les registres 6 avant de se mettre en sommeil. Dans ces registres, il stocke toutes les informations qui seront nécessaires au circuit 5. Ces informations sont notamment les fréquences à écouter et la date du réveil du microprocesseur 8. Le microprocesseur 8 a obtenu ces informations grâce une phase préliminaire de recherche d'abonnée décrite par la norme GSM et implantée de manière connue dans les téléphones mobiles. Une fois cette initialisation faite, le microprocesseur 8 agit sur le commutateur 7. Celui-ci bascule privant d'alimentation le circuit de traitement 12, et alimentant dans le même temps le circuit 5. Dans une variante de l'invention le circuit 5 est alimenté en permanence. Au besoin le commutateur 7 est dédoublable, le circuit 5 étant mis en service avant la coupure de l'alimentation du circuit 12.

Seuls les éléments, d'un téléphone mobile, intéressant l'invention ont été représentés sur la figure 1. De préférence, lors d'une phase de mise en sommeil tous les éléments d'un téléphone mobile qui n'interviennent pas dans les traitements restant à faire sont mis en sommeil. De même on a choisi de représenter la mise en sommeil par une mise hors tension. Il existe d'autres moyens de mettre en sommeil des éléments, comme les priver de leur horloge. Cela a pour effet de suspendre leurs opérations. Une fois le commutateur 7 basculé. On passe à une étape 40 de mise en service du circuit 5.

Le réveil du circuit 5 fait suite à la mise en sommeil du microprocesseur 8. Le circuit 5 lit au fur et à mesure le contenu des registres 6 afin de savoir quelles sont les fréquences qu'il doit écouter les unes après les autres. Il lit aussi quand le microprocesseur 8 doit être réveillé. On passe ensuite à l'étape 41 de détection et de stockage des résultats.

Pour chaque fréquence lue, le circuit 5 paramètre le circuit 13 radioélectrique et consacre 48 millisecondes au maximum à écouter la sortie du démodulateur 18. En effet 48 millisecondes représentent l'intervalle de temps qui sépare deux émissions d'un signal FCB sur une fréquence particulière de balise. Si un signal FCB n'est pas détecté durant cet intervalle c'est qu'il n'y en a pas ou qu'il est trop dégradé pour être exploitable. Au fur et à mesure des détections, ou non détections, le circuit 5 met à jour les registres 6. On passe ensuite à une étape 42.

Dans l'étape 42 le circuit 5 détermine s'il est l'heure de réveiller le microprocesseur 8 ou pas. Avant de s'endormir, le microprocesseur 8 a initialisé un compteur, contenu dans le circuit 5. Le circuit 5 comporte ou est connecté avec une horloge qui se charge de décrémenter le compteur. Lorsque ce compteur tombe à zéro, le circuit 5 sait qu'il est temps de réveiller le microprocesseur 8. Dans ce cas on passe à une étape 43, sinon on continue la détection avec l'étape 41. Si le circuit 5 a déjà écouté toutes les fréquences décrites dans les registres 6, il ne fait plus qu'attendre le moment de réveiller le circuit 12.

Dans l'étape 43 le circuit 5 agit sur le commutateur 7, afin que celui-ci recommence à alimenter le circuit de traitement 12. Cette action endort, de préférence, le circuit 5 et réveille le microprocesseur 8. Ce dernier lit les registres 6 pour connaître les résultats des traitements effectués pendant son sommeil par le circuit 5. On passe à une étape 46 de suite.

Les étapes 44, 45 et 46 sont des traitements qui s'effectue de manière connue et n'influant pas sur la mise en oeuvre du procédé selon l'invention. Dans l'étape 45, comme le rapport signal/bruit n'est pas satisfaisant, le microprocesseur 8 décide qu'il ne peut pas confier la détection des FCB au circuit 5, et il s'en charge lui-même.

## Revendications

1. Téléphone mobile comportant :
- une chaîne de traitement principale pour traiter des signaux radioélectriques, et
- des moyens (5, 7, 8, 11) de mise en sommeil et de réveil de la chaîne de traitement principale,
**caractérisé en ce qu'**il comporte :
- une chaîne de traitement secondaire permettant d'entretenir une activité réduite de réception et de traitement de certains signaux radioélectriques pendant le sommeil de la chaîne principale,
- des registres (6) accessibles à la fois par la chaîne de traitement principale et par la chaîne de traitement secondaire, pour paramétrer la chaîne de traitement secondaire, de préférence en fréquence et en gain de réception, et pour restituer des résultats de traitements de la chaîne secondaire.

2. Téléphone selon la revendication 1, **caractérisé en ce qu'**il comporte:
- un circuit (13) radioélectrique recevant des signaux radioélectriques et produisant des signaux démodulés,
- un circuit (12) de traitement des signaux démodulés, produisant des signaux numériques traités, représentant les signaux de calage en fréquence, et
- dans la chaîne de traitement secondaire un circuit (5) de traitement supplémentaire mis en service pendant le sommeil de la chaîne principale et spécialisée pour détecter des signaux de calage en fréquence à partir des signaux démodulés.

3. Téléphone selon la revendication 2, **caractérisé en ce que** le circuit de traitement supplémentaire comporte en cascade un comparateur (20), un filtre (21) passe bande, un détecteur (22) d'enveloppe, et un comparateur (25).

4. Téléphone selon l'une des revendications 2 à 3, **caractérisé en ce que** le circuit de traitement supplémentaire comporte en cascade un comparateur (27), un mélangeur (28), un filtre (31) passe bas, un filtre (32) moyennant, et un comparateur (35).

5. Téléphone selon l'une des revendications 2 à 4, **caractérisé en ce que** le circuit de traitement supplémentaire comporte des moyens (9, 10, 11) de paramétrage, en fréquence et en gain de réception, du circuit radioélectrique.

6. Procédé de détection de signaux par un téléphone mobile dans lequel, dans une chaîne de traitement principale :
- on reçoit des signaux radioélectriques pour produire des signaux démodulés,
- on produit, à partir des signaux démodulés, des signaux numériques traités, représentant notamment des signaux de calage en fréquence (FCB),
**caractérisé en ce que** :
- on met à jour des paramètres, enregistrés dans des registres accessibles à la fois par la chaîne de traitement principale et par une chaîne de traitement secondaire, de configuration d'une chaîne de traitement secondaire,
- on met en sommeil (39) la chaîne de traitement principale,
- on met en service (40) la chaîne de traitement secondaire, permettant d'entretenir une activité réduite de réception et de traitement de certains signaux radioélectriques, pendant le sommeil de la chaîne de traitement principale,
- on met à jour les registres en fonction de résultats de traitements de la chaîne de traitement secondaire.

7. Procédé selon la revendication 6, **caractérisé en ce que**
- on acquiert (41) avec un circuit de traitement supplémentaire de la chaîne de traitement secondaire des signaux de calage en fréquence à partir de signaux démodulés.

8. Procédé selon la revendication 7, **caractérisé en ce qu'**on met en service le circuit de traitement supplémentaire en fonction de la qualité de réception de signaux de calage reçus (38).

9. Procédé selon l'une des revendications 7 ou 8, **caractérisé en ce qu'**on mémorise (41) les signaux de calages en fréquence acquis dans des registres.

## Patentansprüche

1. Mobiltelefon, das umfasst:
- eine Hauptverarbeitungskette zur Verarbeitung der Funksignale und
- Vorrichtungen (5, 7, 8, 11) zum Einschalten und Auschalten des Stand-by-Zustands für die Hauptverarbeitungskette,
**dadurch gekennzeichnet, dass** es umfasst:
- eine sekundäre Verarbeitungskette, die das Unterhalten einer reduzierten Empfangsaktivität erlaubt, und zur Verarbeitung bestimmter Funksignale während des Stand-by-Zustands der Hauptverarbeitungskette,
- Register (6), auf die sowohl von der Hauptverarbeitungskette als auch von der sekundären Verarbeitungskette zur Parametrisierung der sekundären Verarbeitungskette zugegriffen werden kann, vorzugsweise der Frequenz und Empfangsverstärkung, und zur Wiederherstellung der Verarbeitungsresultate der sekundären Kette.

2. Telefon nach Anspruch 1, **dadurch gekennzeichnet, dass** es umfasst:
- eine Funkschaltung (13), die Funksignale empfängt und demodulierte Signale erzeugt,
- eine Schaltung (12) zur Verarbeitung der demodulierten Signale, die verarbeitete digitale Signale erzeugt, welche die Frequenzverriegelungssignale darstellen, und
- in der sekundären Verarbeitungskette eine zusätzliche Verarbeitungsschaltung (5), die während des Stand-by-Zustands der Hauptverarbeitungskette in Betrieb ist und speziell darauf ausgerichtet ist, auf der Grundlage der demodulierten Signale Frequenzverriegelungssignale zu erfassen.

3. Telefon nach Anspruch 2, **dadurch gekennzeichnet, dass** die zusätzliche Verarbeitungsschaltung in Kaskade geschaltet einen Komparator (20), einen Bandfilter (21), einen HüllkurvenDetektor (22) und einen Komparator (25) umfasst.

4. Telefon nach einem der Ansprüche 2 bis 3, **dadurch gekennzeichnet, dass** die zusätzliche Verarbeitungsschaltung in Kaskade geschaltet einen Komparator (27), einen Mixer (28), einen Tiefpassfilter (31), einen Mittelungsfilter (32) und einen Komparator (35) umfasst.

5. Telefon nach einem der Ansprüche 2 bis 4, **dadurch gekennzeichnet, dass** die zusätzliche Verarbeitungsschaltung Vorrichtungen (9, 10, 11) zur Parametrisierung von Frequenz und Verstärkung der Funkschaltung umfasst.

6. Verfahren zur Erfassung von Signalen durch ein Mobiltelefon, bei dem man in einer Hauptverarbeitungskette:
- Funksignale empfängt, um demodulierte Signale zu erzeugen,
- auf der Grundlage der demodulierten Signale verarbeitete digitale Signale erzeugt, die insbesondere Frequenzverriegelungssignale (FCB) darstellen,
**dadurch gekennzeichnet, dass**:
- Parameter aktualisiert werden, die in Registern gespeichert sind, auf die sowohl von der Hauptverarbeitungskette als auch von einer sekundären Kette zur Parametrierung der sekundären Verarbeitungskette zugegriffen werden kann, mit der Konfiguration einer sekundären Verarbeitungskette,
- die Hauptverarbeitungskette in den Stand-by-Zustand (39) versetzt wird,
- die sekundäre Verarbeitungskette in Betrieb gesetzt (40) wird, wodurch eine reduzierte Empfangsaktivität unterhalten und die Verarbeitung bestimmter Funksignale während des Stand-by-Zustands der Hauptverarbeitungskette ermöglicht wird,
- die Register abhängig von Verarbeitungsresultaten der sekundären Verarbeitungskette aktualisiert werden.

7. Verfahren nach Anspruch 6, **dadurch gekennzeichnet, dass**:
- mit einer zusätzlichen Verarbeitungsschaltung der sekundären Verarbeitungskette auf der Grundlage von demodulierten Signalen Frequenzverriegelungssignale erfasst (41) werden.

8. Verfahren nach Anspruch 7, **dadurch gekennzeichnet, dass** die zusätzliche Verarbeitungsschaltung in Abhängigkeit von der Empfangsqualität empfangener Verriegelungssignale (38) in Betrieb gesetzt wird.

9. Verfahren nach einem der Ansprüche 7 oder 8, **dadurch gekennzeichnet, dass** die erfassten Frequenzverriegelungssignale in Registern gespeichert (41) werden.

## Claims

1. Mobile telephone including:
- a main processing system for processing radioelectric signals, and
- means (5, 7, 8, 11) for placing the main processing system into sleep mode and wake mode,
**characterised by** the fact that it includes:
- a secondary processing system permitting the maintenance of reduced activity of reception and of processing of certain radioelectric signals during the sleep mode of the main system,
- registers (6) accessible both by the main processing system and by the secondary processing system, to configure the secondary processing system, preferably with regard to reception frequency and gain, and to restore results of secondary system processing.

2. Telephone as described in claim 1, **characterised by** the fact that it includes:
- a radioelectric circuit (13) receiving radioelectric signals and producing demodulated signals,
- a circuit (12) for processing the demodulated signals, producing processed digital signals, representing the frequency lock signals, and
- in the secondary processing system an additional processing circuit (5) employed during the sleep mode of the main system and specialised to detect frequency lock signals from the demodulated signals.

3. Telephone as described in claim 2, **characterised by** the fact that the additional processing circuit includes in cascade, a comparator (20), a band-pass filter (21), an envelope detector (22) and a comparator (25).

4. Telephone as described in one of claims 2 to 3, **characterised by** the fact that the additional processing circuit includes in cascade a comparator (27), a mixer (28), a band-pass filter (31) a mean filter (32) and a comparator (35).

5. Telephone as described in one of claims 2 to 4, **characterised by** the fact that the additional processing circuit includes means (9, 10, 11) for configuring the reception frequency and gain of the radioelectric circuit.

6. Process for detection of signals by a mobile telephone in which, in a main processing system:
- radioelectric signals are received to produce demodulated signals,
- from the demodulated signals, processed digital signals are produced, representing in particular frequency lock signals (FCB),
**characterised by** the fact that:
- parameters, stored in registers accessible both by the main processing system and by a secondary processing system, for configuration of a secondary processing system, are updated,
- the main processing system is put into sleep mode (39),
- the secondary processing system is put into service (40), permitting maintenance of reduced activity of reception and of processing of certain radioelectric signals, during the sleep mode of the main processing system,
- the registers are updated according to the processing results of the secondary processing system.

7. Process as described in claim 6, **characterised by** the fact that
- frequency lock signals are obtained (41) from demodulated signals with a processing circuit additional to the secondary processing system.

8. Process as described in claim 7, **characterised by** the fact that the additional processing circuit is put into service depending on the reception quality of locking signals received (38).

9. Process as described in one of claims 7 or 8, **characterised by** the fact that the frequency lock signals obtained are stored in registers.
